# EUROPÄISCHE PATENTANMELDUNG

(11) **EP 0 768 717 A2**
(43) Veröffentlichungstag der Anmeldung: **16.04.1997**
(21) Anmeldenummer: 96810599.9
(22) Anmeldetag: 09.09.1996
(51) Int. Cl.: H01L 29/739, H01L 29/745, H01L 29/861

(54) **Leistungshalbleiterelement**

(30) Priorität: 13.10.1995 DE 19538090
(71) Anmelder: ASEA BROWN BOVERI AG, 5401 Baden (CH)
(72) Erfinder: Bauer, Friedhelm, Dr., 5034 Suhr (CH)

(57) **Zusammenfassung**

Es wird ein Leistungshalbleiterelement angegeben, bei welchem die Löcher-Absaug-Effizienz von wannenförmigen, in ein Halbleitersubstrat eingelassenen, vorzugsweise p⁺ dotierter Gebiete durch ein elektrisch nicht leitende, vergrabene Schicht herabgesetzt wird. Diese Massnahme hat eine Erhöhung der Ladungsträgerdichte über die gesamte Dicke des Bauelements zur Folge. Deshalb erhält man einen geringeren Durchlasswiderstand.

## Beschreibung

### Technisches Gebiet

Die Erfindung bezieht sich auf das Gebiet der Leistungshalbleiterelektronik. Sie geht aus von einem Leistungshalbleiterelement gemäss dem Oberbegriff des ersten Anspruchs.

### Stand der Technik

Ein solches Leistungshalbleiterelement wird bereits in der EP-A1-0 528 349 beschrieben. Es handelt sich dabei um einen Bipolartransistor mit isoliert angeordneter Steuerelektrode (IGBT). Ein IGBT und auch andere Leistungshalbleiterelemente wie Hochleistungs-Dioden oder Thyristoren mit isoliertem Gate (IGTh oder BRT) weisen im wesentlichen ein Halbleitersubstrat auf, in welches kathodenseitig eine Vielzahl von wannenförmigen Gebieten eingelassen ist. Die wannenförmigen Gebiete weisen einen anderen Leitfähigkeitstyp auf als das Halbleitersubstrat. Diese wannenförmigen Gebiete wirken je nach Betriebszustand des Bauelements als Ladungsträger-Kollektoren. Falls die wannenförmigen Gebiete p dotiert sind, so saugen sie Löcher an.

IGBTs weisen im Gegensatz zu Thyristoren den Vorteil auf, dass ihre Steuerelektrode isoliert angeordnet ist und dadurch eine Spannungssteuerung statt einer Stromsteuerung möglich ist. Dies ist insbesondere im Hinblick auf die Steuerleistung von Vorteil.

Der verglichen mit Thyristoren hohe Durchlassspannungsabfall des IGBT verwehrte ihm bis jetzt den Durchbruch für höchste Spannungen. Der höhere Spannungsabfall ist insbesondere darin begründet, dass die Plasmadichte im Halbleitersubstrat gegenüber dem Thyristor geringer ist. Mit anderen Worten, es sind weniger Ladungsträger vorhanden, so dass der ohmsche Widerstand grösser ist.

Durch spezielle Dotierungskonzentrationen und Trägerlebensdauer beschränkende Massnahmen wird bei der oben genannten Schrift versucht, einen niedrigen Durchlassspannungsabfall und eine kurze Einschaltzeit zu erreichen. Verglichen mit Thyristoren sind die so dimensionierten IGBTs hinsichtlich des Durchlasswiderstandes aber immer noch weit unterlegen.

Mit anderen Technologien, wie zum Beispiel den Trench- oder Graben-IGBTs wird versucht, diesem Problem Herr zu werden. Trench-IGBTs sind jedoch prozesstechnisch derart schwierig herzustellen, dass diese derzeit noch keine wirtschaftliche Alternative darstellen.

### Darstellung der Erfindung

Aufgabe der vorliegenden Erfindung ist es deshalb, ein Leistungshalbleiterelement anzugeben, welches einen niedrigen Durchlasswiderstand aufweist und dennoch einfach und kostenkompetitiv hergestellt werden kann. Diese Aufgabe wird bei einem Leistungshalbleiterelement der eingangs genannten Art durch die Merkmale des ersten Anspruchs gelöst.

Kern der Erfindung ist es also, dass Mittel vorgesehen sind, welche ein axiales Fliessen von Ladungsträgern, insbesondere von Löchern, im Bereich des Überganges vom Halbleitersubstrat zu den wannenförmigen Gebieten weitgehend verhindern. Die Ladungsträger können nicht mehr axial in die wannenförmigen Gebiete fliessen, sondern müssen lateral ausweichen. Dadurch wird die Plasmadichte der Ladungsträger im Halbleitersubstrat vergrössert und der Durchlassspannungsabfall sinkt ab. Dies erreicht man am einfachsten mit einer vergrabenen, elektrisch nicht leitenden Schicht, welche im Bereich des Überganges von den wannenförmigen Gebieten zum Halbleitersubstrat angeordnet ist.

Die Erfindung wird mit Vorteil für IGBTs, Thyristoren mit isoliertem Gate und auch für Dioden eingesetzt. Die nicht leitende Schicht ist, verglichen mit der Tiefe der wannenförmigen Gebiete, dünn und wird mit Vorteil an dem dem Halbleitersubstrat zugewandten Rand der wannenförmigen Gebiete angeordnet. In lateraler Richtung ist die nicht leitende Schicht periodisch unterbrochen und kann ein wenig über die laterale Begrenzung der wannenförmigen Gebiete hinausragen. Um das Element gegenüber Latch-Up noch unempfindlicher zu machen, kann die nicht leitende Schicht in einem zentralen Bereich der wannenförmigen Gebiete auch unterbrochen sein.

Vorteilhaft an der Erfindung ist insbesondere, dass die erfindungsgemässe Struktur z.B. für IGBTs einen Durchlasswiderstand aufweist, welcher im Bereich eines Thyristors liegt, dass die erfindungsgemässe Struktur aber dennoch mit wirtschaftlich vertretbarem Aufwand herstellbar ist.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Ein Schnittbild durch einen Teil einer Diode, welche erfindungsgemäss ausgebildet ist;
- **Fig. 2**: Ein Schnittbild durch einen Teil eines IGTh oder BRT, welcher erfindungsgemäss ausgebildet ist;
- **Fig. 3**: Ein Schnittbild durch einen Teil eines IGBT, welcher erfindungsgemäss ausgebildet ist,
- **Fig. 4**: Eine Aufsicht auf einen Teil eines erfindungsgemässen IGBTs mit streifenförmigen Emittergebieten;
- **Fig. 5**: Eine Aufsicht auf einen Teil eines erfindungsgemässen IGBTs mit inselförmigen Emittergebieten;
- **Fig. 6**: Eine Aufsicht auf einen Teil eines erfindungsgemässen IGBTs mit balkenförmigen Emittergebieten; und
- **Fig. 7**: Eine Variante für die Realisierung der nicht leitenden Schicht.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

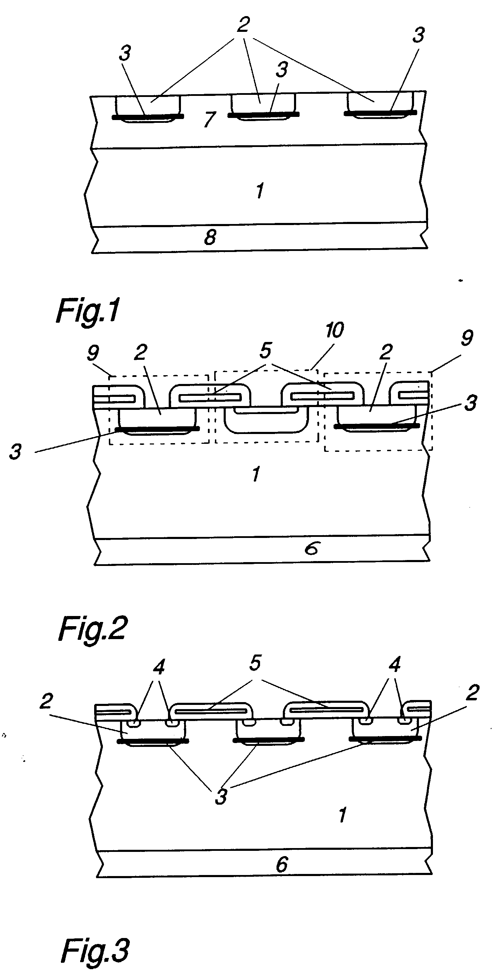

Nachfolgend wird die Erfindung zunächst einmal anhand eines IGBTs erläutert: Figur 3 zeigt einen Ausschnitt eines IGBTs im Schnitt. Mit 1 ist ein normalerweise n dotiertes Halbleitersubstrat bezeichnet. Dieses Halbleitersubstrat wird von einer ersten, in der Figur oberen und einer zweiten, in der Figur unteren Hauptfläche begrenzt. In dieses Halbleitersubstrat 1 ist von der ersten Hauptfläche her eine Vielzahl von z.B. p⁺ dotierten, wannenförmigen Gebieten 2 eindiffundiert. In diesen Gebieten 2 sind n⁺ dotierte Emittergebiete 4 vorgesehen. An die zweite Hauptfläche schliesst sich eine p dotierte Schicht 6 an. Diese Schicht wird von einer der Übersichtlichkeit halber nicht dargestellten Metallisierung überdeckt und bildet dadurch eine Hauptelektrode. Die andere Hauptelektrode wird durch eine ebenfalls nicht dargestellte Metallisierung gebildet, welche die Emittergebiete 4 und die wannenförmigen Gebiete 2 kontaktiert. Die Steuerelektrode wird durch eine isoliert angeordnete leitende Schicht 5 gebildet, welche das Halbleitersubstrat in den Bereichen zwischen zwei wannenförmigen Gebieten 2 überdeckt und mit den Emittergebieten 4 überlappt. Die vorstehende Beschreibung entspricht einer konventionellen, planaren IGBT Struktur, welche mit einfacher DMOS Technologie hergestellt werden kann. Ein fertiger IGBT besteht aus einer Vielzahl von parallelgeschalteten, je ein wannenförmiges Gebiet umfassenden Einheitszellen.

Versuche und Simulationen haben nun ergeben, dass im Halbleitersubstrat 2 bei leitendem IGBT unterhalb der wannenförmigen Gebiete 2 eine vergleichsweise geringe Löcherdichte vorherrscht. Dies liegt daran, dass die wannenförmigen Gebiete 2 Löcher, welche von der Schicht 6 her kommen, sehr effizient aus dem Halbleitersubstrat absaugen. Ziel der Erfindung ist es nun, den Volumenanteil im Bauelement, in welchem Löcherabsaugung eintritt, zu reduzieren. Dies wird dadurch erreicht, dass im Bauelement Mittel vorgesehen sind, welche ein Fliessen von Löchern von dem Halbleitersubstrat 1 in die wannenförmigen Gebiete 2 in axialer Richtung, d.h. in Figur 3 von unten nach oben, möglichst verhindern, in einer lateralen, zur axialen Richtung im wesentlichen rechtwinklig verlaufenden Richtung aber erlauben.

Diese Aufgabe kann durch eine elektrisch nicht leitende Schicht 3 gelöst werden. Die Schicht 3 wird mit Vorteil noch innerhalb der wannenförmigen Gebiete 2, kurz vor dem Übergang zum Halbleitersubstrat 1 angeordnet. In axialer Richtung ist die Schicht 3 vergleichsweise dünn, d.h. lediglich Bruchteile von µm bis ungefähr 1 µm dick. In lateraler Richtung ist die Schicht 3 periodisch unterbrochen. Sie kann wenige µm über die wannenförmigen Gebiete 2 hinausragen. Mit Erfolg erprobt wurde eine Schicht 3, welche in den wannenförmigen Gebieten 2 von der ersten Hauptfläche her gesehen in einer Tiefe von 3 µm und 1 µm vor dem Übergang zum Halbleitersubstrat 1 vergraben wurde. Lateral ragte die Schicht 3 ca. 5 µm über die Begrenzung der wannenförmigen Gebiete 2 hinaus.

Vorzugsweise wird die Schicht 3 aus SiO₂ hergestellt, andere elektrisch nicht leitende Materialien sind aber auch denkbar. Die Schicht 3 hindert die wannenförmigen Gebiete 2 daran, Löcher über die Sperrschicht zum Halbleitersubstrat abzusaugen. Den Löchern bleibt nur noch der Weg durch das schmale Fenster zwischen dem nicht dargestellten ersten Hauptelektroden- oder Kathodenkontakt und der isolierenden Schicht 3. Durch diese Massnahme erreicht man eine sehr stark erhöhte Löcherdichte. Versuche und Simulationen haben ergeben, dass das Löcherdichteprofil über die gesamte Dicke des IGBT dem eines GTO ähnlich wird. Dieses Ziel wurde genau angestrebt, um den Durchlasswiderstand des IGBT zu erniedrigen. Für einen planaren 3.3 kV IGBT mit der erfindungsgemässen Schicht wurde bei einer Temperatur von 400 K und einem Strom von 50 A/cm² gegenüber einem entsprechenden konventionellen Element eine Reduktion des Durchlassspannungsabfalls von 5.329 V auf 3.339 V erreicht. Für einen Strom von 100 A/cm² wurde sogar eine Reduktion von 6.221 V auf 3.918 V erreicht.

Die erfindungsgemässe elektrisch nicht leitende Schicht 3 kann mittels verschiedener für andere Halbleitertechnologien bewährter Technologien hergestellt werden. Eine erste aber relativ aufwendige Variante ist die Hochenergieimplantation von Sauerstoff mit anschliessendem Temperaturschritt zur Bildung der SiO₂-Schicht.

Einfacher ist das Wachsen einer epitaktischen Schicht ausgehend von einem vorbehandelten Wafer mit periodisch unterbrochener SiO₂-Schicht. Da die SiO₂-Schicht dünn ist, wächst die epitaktische Schicht auch lateral über die SiO₂-Schicht. In der gewachsenen Schicht werden anschliessend die geforderten wannenförmigen p⁺ dotierten Gebiete hergestellt.

Aus der Power-ASIC-Technologie sind bereits Technologien bekannt, mittels welcher vergrabene SiO₂-Schichten hergestellt werden können. Diese werden zur dielektrischen Isolation von Funktionsgruppen im ASIC benötigt.

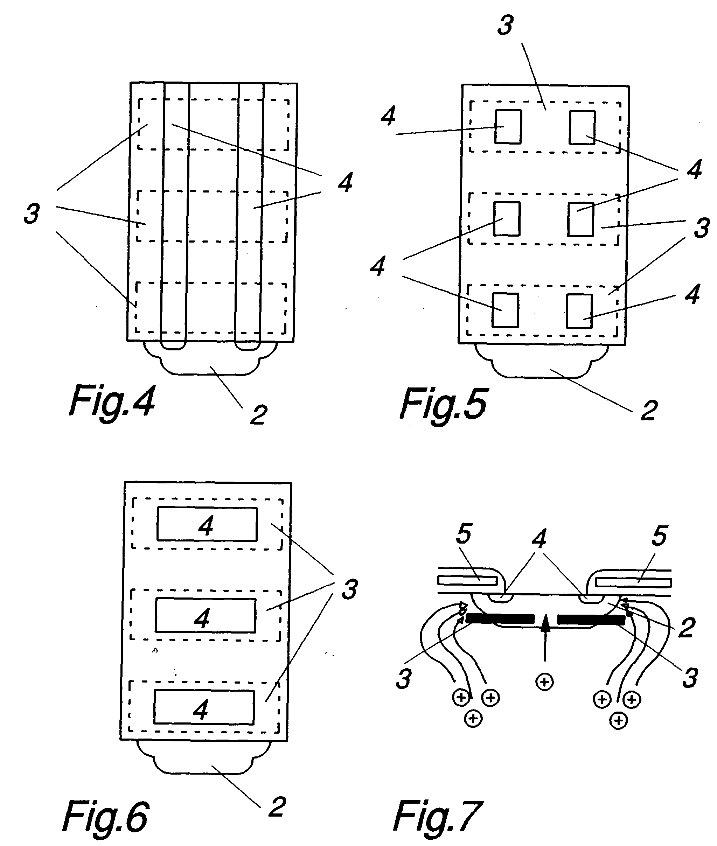

Sollte die Latch-Up-Empfindlichkeit eines erfindungsgemäss ausgerüsteten IGBTs aufgrund des reduzierten Löcherabsaugeffekts der wannenförmigen Gebiete 2 allzu stark zunehmen, so ist zu empfehlen, die elektrisch nicht leitende Schicht 3 in einem zentralen Bereich der wannenförmigen Gebiete unterbrochen auszuführen. Ein Teil der Löcher kann dann immer noch in dem zentralen Bereich der wannenförmigen Gebiete 2 abgesaugt werden. Ein Beispiel für diese Ausführungsform zeigt Figur 7.

Ein weiterer Freiheitsgrad bei der Dimensionierung eines IGBTs stellt die Form der Emittergebiete 4 dar. Es sind Varianten mit, von oben gesehen, streifenförmigen Emittergebieten (Figur 4), inselförmigen Emittergebieten (Figur 5) und balkenförmigen Emittergebieten (Figur 6) bekannt. Jede der Varianten hat ihre eigenen Vorteile. Die Erfindung ist für jede dieser Varianten vorteilhaft einsetzbar. Die Figuren 4-6 zeigen von oben, dass die elektrisch nicht leitende Schicht 3 z.B. entlang der streifenförmigen Emittergebiete 2 unterbrochen angeordnet sein soll. Dasselbe gilt für die inselförmigen Emittergebiete 2 (Figur 5), bei welchen für je zwei Gebiete eine nicht leitende Schicht 3 vorgesehen werden soll. Analoges gilt für balkenförmige Emittergebiete 2 (Figur 6). Hier wird jeder Balken von einer Schicht 3 umgeben.

Selbstverständlich kann die Schicht 3, im Gegensatz zu den in den Figuren 4-6 dargestellten Beispielen, auch durchgehend ausgeführt sein. Es können sich jedoch dann dieselben Latch-Up-Probleme ergeben, wie sie im Zusammenhang mit Figur 7 erläutert wurden.

Bis jetzt wurde die Erfindung lediglich am Beispiel eines IGBT dargestellt. Sie ist jedoch nicht darauf beschränkt, sondern kann auch bei Dioden, insbesondere bei SPEED-Dioden, und bei IGTh oder BRT eingesetzt werden:

Figur 2 zeigt einen Ausschnitt eines BRT oder IGTh im Schnitt. Im Gegensatz zum IGBT sind zwei Typen von Einheitszellen vorhanden: eine Transistor-Zelle 9, welche durch eine 3-Schicht-Struktur charakterisiert ist, und eine Thyristor-Zelle 10, welche ein 4-Schicht-Struktur aufweist. Die Funktionsweise eines IGTh oder BRT ist in den Druckschriften JP 63-310171 A und DE 40 24 526 Al beschrieben. Deren Offenbarung soll an dieser Stelle ausdrücklich miteinbezogen werden und die Funktion eines derartigen Elements braucht deshalb an dieser Stelle nicht noch einmal wiederholt zu werden.

Bei einem IGTh oder BRT saugt das wannenförmige p⁺ Gebiet 2 der Transistor-Einheitszelle 9 u.U. derart stark Löcher ab, dass ein Einrasten der Thyristor-Zelle 10 verhindert wird. Um die Löcher-Saug-Effizienz der Transistorzellen 9 herabzusetzen, kann analog zu IGBT eine elektrisch nicht leitende Schicht in der p⁺ Wanne 2 der Transistor-Zelle 9 vorgesehen werden.

Die Erfindung wird aber auch mit Vorteil für sogenannte SPEED-Dioden eingesetzt. Figur 1 zeigt ein solches Beispiel. Bei derartigen Dioden sind im p dotierten Anodenemitter 7 wannenförmige p⁺ dotierte Gebiete 2 vorgesehen. Werden diese Gebiete 2 ebenfalls mit erfindungsgemässen nicht leitenden Schichten 3 ausgerüstet, so erhält man durch die verminderte Löcher-Saug-Effizienz eine Diode mit höherer Resistenz gegen dynamische Lawinendurchbrüche (dynamic avalanche break down).

Insgesamt ergeben sich mit der erfindungsgemässen Massnahme Leistungshalbleiterelemente, deren Plasmadichte über die gesamte Dicke des Bauelements verglichen mit konventionellen Strukturen höher ist. Dadurch erreicht man einen deutlich niedrigeren Durchlasswiderstand.

### Bezugszeichensliste

- 1: Halbleitersubstrat
- 2: wannenförmige Gebiete
- 3: elektrisch nicht leitende Schicht
- 4: Emittergebiet
- 5: Gateelektrode
- 6: Kollektorschicht
- 7: Anodenemitter
- 8: Kathodenemitter
- 9: Transistorzelle
- 10: Thyristorzelle

## Patentansprüche

1. Leistungshalbleiterelement umfassend:
(a) ein Halbleitersubstrat (1) eines ersten Leitfähigkeitstyps, wobei das Halbleitersubstrat (1) von einer ersten und einer zweiten Hauptfläche begrenzt wird;
(b) eine Vielzahl von wannenförmigen Gebieten (2) eines zweiten, dem ersten entgegengesetzten Leitfähigkeitstyps, welche Gebiete (2) von der ersten Hauptfläche her in das Halbleitersubstrat (1) eingelassen sind;
dadurch gekennzeichnet, dass
(c) in einem Bereich, in welchem die wannenförmigen Gebiete (2) in einer axialen Richtung, von der ersten Hauptfläche zur zweiten gesehen, in das Halbleitersubstrat (1) übergehen, Mittel (3) vorgesehen sind, welche ein Fliessen von Ladungsträgern des zweiten Leitfähigkeitstyps von dem Halbleitersubstrat (1) in die wannenförmigen Gebiete (2) entgegen der axialen Richtung möglichst verhindern, in einer lateralen, zur axialen Richtung im wesentlichen rechtwinklig verlaufenden Richtung aber erlauben.

2. Leistungshalbleiterelement nach Anspruch 1, dadurch gekennzeichnet, dass die Mittel eine elektrisch nicht leitende Schicht (3) umfassen.

3. Leistungshalbleiterelement nach Anspruch 2, dadurch gekennzeichnet, dass die nicht leitende Schicht (3) in lateraler Richtung periodisch unterbrochen ist, dass die Schicht (3) verglichen mit einer Tiefe der wannenförmigen Gebiete (2) in axialer Richtung dünn aber noch innerhalb der wannenförmigen Gebiete (2) ausgebildet ist und in lateraler Richtung im Bereich von Bruchteilen von µm bis zu wenigen µm über die wannenförmigen Gebiete (2) hinausragt

4. Leistungshalbleiterelement, nach einem der Ansprüche 1 bis 3, dadurch gekennzeichnet, dass
(a) das Leistungshalbleiterelement die Funktion eines Bipolartransistors mit isoliert angeordneter Gateelektrode (5) aufweist;
(b) in den wannenförmigen Gebieten (2) Emittergebiete (4) des ersten Leitfähigkeitstyps angeordnet sind, welche Emittergebiete (4) mit einer ersten Hauptelektrode verbunden sind;
(c) die Gateelektrode (5) die erste Hauptfläche in einem Bereich zwischen zwei wannenförmigen Gebieten (2) überdeckt und mit den Emittergebieten (4) überlappt;
(d) benachbart zur zweiten Hauptfläche eine Kollektorschicht (6) des zweiten Leitfähigkeitstyps vorgesehen sind, welche mit einer zweiten Hauptelektrode verbunden ist.

5. Leistungshalbleiterelement nach Anspruch 4, dadurch gekennzeichnet, dass die Emittergebiete (4) als Streifen ausgebildet sind und die nicht leitende Schicht (3) in Richtung der Streifen unterbrochen sind.

6. Leistungshalbleiterelement nach Anspruch 4, dadurch gekennzeichnet, dass die Emittergebiete (4) als Inseln ausgebildet sind und die nicht leitende Schicht (3) unterbrochen ist, so dass sie jeweils auf zwei gegenüberliegende Inseln begrenzt ist.

7. Leistungshalbleiterelement nach Anspruch 4, dadurch gekennzeichnet, dass die Emittergebiete(4) in der Form eines sich im wesentlichen über das ganze wannenförmige Gebiet (2) erstreckenden Balkens ausgebildet sind und dass die nicht leitende Schicht (3) unterbrochen ist, so dass sie aufjeweils einen Balken begrenzt ist.

8. Leistungshalbleiterelement nach Anspruch 4, dadurch gekennzeichnet, dass die nicht leitende Schicht (3) in einem zentralen Bereich der wannenförmigen Gebiete (2) unterbrochen ist.

9. Leistungshalbleiterelement nach einem der Ansprüche 1 bis 3, dadurch gekennzeichnet, dass
(a) das Leistungshalbleiterelement die Funktion einer Diode aufweist;
(b) die wannenförmigen Gebiete (2) von einer an die erste Hauptfläche grenzenden ersten Schicht (7) des zweiten Leitfähigkeitstyps umgeben sind, wobei diese erste Schicht schwächer dotiert ist als die wannenförmigen Gebiete (2) ;
(c) angrenzend an die zweite Hauptfläche eine zweite Schicht (8) desselben Leitfähigkeitstyps wie das Halbleitersubstrat (1) vorgesehen ist, wobei diese zweite Schicht stärker dotiert ist als das Halbleitersubstrat (1).

10. Leistungshalbleiterelement nach einem der Ansprüche 1 bis 3, dadurch gekennzeichnet, dass
(a) das Leistungshalbleiterelement die Funktion eines IGTh oder BRT aufweist und Transistorzellen (9) und Thyristorzellen (10) aufweist;
(b) die wannenförmigen Gebiete (2) der Transistorzellen (9) mit der nicht leitenden Schicht (3) ausgerüstet sind.
